# EUROPEAN PATENT APPLICATION

(11) **EP 4 831 367 A1**
(43) Date of publication of application: **28.10.2026**
(21) Application number: 24923217.4
(22) Date of filing: 29.07.2024
(51) Int. Cl.: C30B 29/40, C30B 11/02, C30B 29/60

(54) **INDIUM PHOSPHIDE CRYSTAL CONTAINING SULFUR AND TIN, SINGLE CRYSTAL WAFER, PREPARATION METHOD FOR INDIUM PHOSPHIDE CRYSTAL, AND DEVICE**

(30) Priority: 08.02.2024 CN 202410178125
(71) Applicant: Beijing Tongmei Xtal Technology Co., Ltd., Beijing 101113 (CN); Chao Yang Tongmei Xtal Technology Co., Ltd., Chaoyang, Liaoning 122304 (CN); Baoding Tongmei Xtal Manufacture Co., Ltd., Baoding, Hebei 072650 (CN)
(72) Inventor: XIAO, Yadong, Beijing 101113 (CN); ZHANG, Shuhui, Beijing 101113 (CN); SHI, Ning, Beijing 101113 (CN); HU, Chengbin, Liaoning 122300 (CN)
(74) Representative: Cohausz & Florack
(86) International application number: PCT/CN2024/108240
(87) International publication number: WO 2025/167002

(57) **Abstract**

An indium phosphide crystal containing sulfur and tin, a single crystal wafer, a preparation method for the indium phosphide crystal and a device. Specifically, the present invention relates to an indium phosphide crystal, which is an N-type indium phosphide crystal, wherein the indium phosphide crystal contains 0.5-500 ppm of sulfur and 0.5-1000 ppm of tin. The present invention also relates to a method for preparing the indium phosphide crystal doped with sulfur and tin, and a device prepared by using the indium phosphide single crystal. The obtained indium phosphide crystal doped with sulfur and tin has low dislocation density, few defects and high yield.

## Description

### Cross-reference to related applications

This application claims priority to Chinese Patent Application No. 202410178125.7 entitled "Indium Phosphide Crystal Containing Sulfur and Tin, Single Crystal Wafer, Preparation Method For Indium Phosphide Crystal and Device" filed on February 8, 2024, which is hereby incorporated by reference in its entirety.

### Technical field

The present application relates to the field of semiconductor processing and manufacturing, in particular to indium phosphide crystal and preparation method thereof. The present application also relates to an indium phosphide single crystal wafer prepared from the indium phosphide crystal and a preparation method thereof, as well as a device comprising the indium phosphide crystal.

### Background

Indium phosphide (InP), as a semiconductor material of III-V compound, exhibits higher electron mobility than silicon or gallium arsenide, and also has relatively high photoelectric conversion efficiency, relatively strong radiation resistance and relatively high thermal conductivity. These excellent properties make it widely used in various fields such as integrated circuits, high-speed and high-frequency devices, optoelectronic devices, and optical fiber communications.

The manufacturing of an InP single crystal wafer typically includes the steps of growing a single crystal, cutting out a rough wafer from a single crystal rod, edge grinding the rough wafer, lapping, rough polishing, fine polishing, cleaning, drying, and so on. In order to broaden the application range of indium phosphide single crystal wafer and improve its performance, doping is usually used to obtain electrical properties (such as carrier concentration and resistivity) required for applications. Doping elements include sulfur, tin, zinc, iron and the like. N-type InP single crystal wafers with high carrier concentration are obtained by doping with sulfur or tin; and P-type InP single crystal wafers with high carrier concentration are obtained by doping with zinc; and semi-insulating InP single crystal wafers are obtained by doping with iron. However, the growth process of the above two semiconducting indium phosphide single crystals (namely P-type InP single crystal and N-type InP single crystal) still inevitably faces the problem of low stacking fault energy of indium phosphide crystals. Due to their low stacking fault energy, twins readily occur during the growth process, and the etch pit density is relatively high, generally reaching hundreds, thousands or even tens of thousands per square centimeter (cm⁻²), which will seriously affect the yield of indium phosphide crystals.

### Summary

Therefore, there is a need in the existing technology for an InP crystal with relatively low etch pit density, no twin defects, and relatively good conductivity and a preparation method thereof.

The present application is proposed to solve the above problems. By incorporating two or more incorporation elements into a growth melt of indium phosphide crystals, the etch pit density is reduced and the formation of defects such as twins is inhibited, thereby improving the yield of indium phosphide single crystals.

Specifically, the first aspect of the present application provides an indium phosphide crystal, which is an N-type indium phosphide single crystal, the indium phosphide crystal contains 0.5 ppm to 500 ppm of sulfur (S) and 0.5 ppm to 1000 ppm of tin (Sn).

Another aspect of the present application provides a preparation method of an indium phosphide crystal, comprising a step of placing phosphorus, an indium phosphide polycrystal, a doping agent comprising an element sulfur, a doping agent comprising an element tin, together with a sealant, into a growth vessel such as a crucible provided with a seed crystal; and a step of placing said vessel in a crystal growth furnace and heating to a temperature of the melting point of indium phosphide or higher; preferably, the element sulfur in the obtained indium phosphide crystal is present in an amount of 0.5 ppm to 500 ppm, and the element tin is present in an amount of 0.5 ppm to 1000 ppm.

Still another aspect of the present application provides an indium phosphide single crystal wafer, prepared from the N-type indium phosphide single crystal as described above or obtained by the method as described above.

Still another aspect of the present application provides an electronic device or optoelectronic device, prepared from the indium phosphide single crystal wafer as described above or containing a component prepared from the indium phosphide single crystal wafer as described above.

Still another aspect of the present application provides the use of a combination of a doping agent containing an element sulfur and a doping agent containing an element tin or use of a doping agent containing both an element sulfur and an element tin for reducing etch pit density, reducing twin defects, and/or improving the yield of indium phosphide crystals while increasing carrier concentration during the production process of indium phosphide crystals.

The N-type indium phosphide crystal co-doped with sulfur and tin obtained by the present application has relatively low etch pit density (also known as dislocation density) and a reduced twin formation, thus has a high yield, and can lead to a single crystal wafer with uniform and stable performance. Meanwhile, the resulting N-type indium phosphide crystal has excellent electrical conductivity. Thus it can be applied in optoelectronic devices such as lasers and photodetectors, electronic devices such as transistors, high-frequency components and the like.

### Description of the drawings

FIG. 1 is a cross-sectional view of an embodiment of a crystal growth apparatus containing a sealed vessel for the growth of indium phosphide single crystals doped with sulfur and tin.
FIG. 2 is a schematic diagram of a single crystal rod fixing device used in the preparation of a single crystal wafer of the present application.

### Detailed description

In order to make the technical objective, technical solutions, and beneficial technical effects of the present application clearer, the following further describes the present application in detail with reference to the specific embodiments. It should be understood that the embodiments and examples described in this specification are merely for the purpose of explaining the present application, and are not intended to limit the application.

For the sake of brevity, only some numerical ranges are explicitly disclosed herein. However, any lower limit may be combined with any upper limit to form a range that is not explicitly described; and any lower limit may be combined with other lower limit to form an unspecified range; and any upper limit may be combined with any other upper limit to form an unspecified range. Further, although not explicitly specified, each point or single value between the endpoints of a range is included in the range. Thus, every point or individual value may serve as its own lower or upper limit and be combined with any other point or individual value or any other lower or upper limit, to form a range not explicitly recited.

Unless stated otherwise, all the embodiments and the preferred embodiments of the present application can be combined with each other to form a new technical solution, and such a technical solution should be considered to be included in the disclosure of the present application.

Unless stated otherwise, all technical features and optional technical features or preferred technical features of the present application can be combined with each other to form a new technical solution, and such a technical solution should be considered to be included in the disclosure of the present application.

As previously described, the present application provides an indium phosphide crystal, which is an N-type indium phosphide single crystal, wherein the indium phosphide crystal comprises 0.5 ppm to 500 ppm of sulfur and 0.5 ppm to 1000 ppm of tin.

Although element sulfur and element tin are doping elements commonly used in the existing technology for forming N-type indium phosphide crystals, both are usually used alone, and no sulfur/tin co-doped indium phosphide crystals have been reported. Even though indium phosphide crystals comprising both element sulfur and element tin may possibly be involved in an occasional disclosure of the existing technology, one element serves as the main element while the other element exists as a trace impurity element, and the content ratios of the two elements greatly differ from each other.

Without being bound by any theory, the inventors have found that:
(1) In actual crystal growth, element sulfur has significant impurity hardening effect in InP. Adding a certain amount of element sulfur can effectively strengthen the lattice strength of InP crystal, thus greatly reducing the point defect density of InP crystal. However, InP doped with element sulfur is prone to twinning in crystal growth, resulting in the problem of low single crystal ratio, which is also a reason for the high cost of InP single crystal. Especially in recent years, the requirements for the carrier concentration of N-type InP crystals on the market are increasingly high, which requires more doping agents containing element sulfur to be added in the growth process of InP crystals, thereby greatly increasing the probability of twinning in the growth process of InP crystals and greatly reducing the single crystal ratio of crystals.
(2) In the actual production process, the addition of element tin as N-type doping agent (also known as dopant) can inhibit the formation of twin crystals to a certain extent, which may be due to the fact that the introduction of element tin improves the viscosity of the melt during the growth of InP crystals, thereby improving the stability of indium phosphide hot melt. However, element tin has little effect on strengthening the lattice strength, so that the point defect density of tin-doped InP crystals is relatively high, which may reach hundreds or even thousands (cm⁻²). Moreover, due to the small segregation coefficient of element tin in the growth process of InP crystals, it is difficult to realize the growth of InP crystals with high carrier concentration, especially at the head of crystal rods (according to J.B. Mullin et al., "Crystal Growth and properties of group IV doped indium phosphide", Journal of Crystal Growth, Vols. 13/14 (1972) 640-646, North-Holland Publishing Co., the segregation coefficient of Sn in the InP crystal is 2.1E-2). In order to meet the market demand for high carrier concentration, it is necessary to add a large amount of doping agent containing element tin. Even so, it is difficult to grow a crystal meeting the market demand at the head of the crystal, and the high tin content basically remains at the tail, which will damage the single crystal formation of InP crystal to some extent.
(3) In the present application, sulfur and tin are used as N-type doping agent(s) in a certain proportions, and co-doped into indium phosphide crystals, which can not only reduce the etch pit density of the crystal, but also inhibit the formation of twin crystals to a certain extent. That is, they lead to a certain extent of synergistic effect, which effectively improves the crystallinity (yield) of single crystals. Furthermore, adjusting the doping ratio can fully meet the application requirements of low etch pit density and high carrier concentration.

As used herein, the term "segregation coefficient", also known as the effective partition coefficient, refers to the different solubility of impurities in different phases at the solid-liquid interface, resulting in the different concentrations of impurities distributed in materials on both sides of the interface. The segregation coefficient is expressed by K, K = (solubility of impurity in solid phase)/(solubility of impurity in liquid phase) (K = Cₛ/Cₗ). The segregation coefficients of elements can be determined by those skilled in the art by using methods known in the art, for example, according to the method described in the article by Fang Dunfu et al., titled "The Growth and Characterics of S-doped Low Dislocation InP Single Crystals" (Journal of Applied Sciences, Vol. 1, Issue 3, Jul. 1983).

In some embodiments of the present application, element sulfur in the indium phosphide crystal may be present in an amount of 0.5 ppm to 500 ppm. For example, the doping amount of element sulfur may 0.5 ppm, 0.8 ppm, 1 ppm, 2 ppm, 3 ppm, 4 ppm, 5 ppm, 10 ppm, 20 ppm, 40 ppm, 50 ppm, 80 ppm, 100 ppm, 200 ppm, 300 ppm, 400 ppm, 500 ppm, or the like, or may be within an arbitrary range formed with any of the above amounts or any of the amounts disclosed in the examples of the present application as end values.

In some embodiments of the present application, element tin in the indium phosphide crystal may be present in an amount of 0.5 ppm to 1000 ppm. For example, the doping amount of element tin may be 0.5 ppm, 1 ppm, 2 ppm, 3 ppm, 4 ppm, 5 ppm, 6 ppm, 7 ppm, 8 ppm, 9 ppm, 10 ppm, 20 ppm, 40 ppm, 50 ppm, 80 ppm, 100 ppm, 200 ppm, 300 ppm, 400 ppm, 500 ppm, 800 ppm, 1000 ppm, or the like, or within an arbitrary range formed with any of the above amounts or any of the amounts disclosed in the examples of the present application as end values.

In some embodiments of the present application, the indium phosphide crystal may contain other elements added or doped for other purposes, such as iron (Fe) or the like, in addition to the element sulfur and the element tin.

It should be noted that the indium phosphide crystals provided herein are typically in the form of single crystal rods. For indium phosphide crystal in the form of single crystal rod, it has been found that the content of a doping element (which is positively correlated with carrier concentration, CC) varies at different cross sections along the growth direction of single crystal rod. It is mainly related to the segregation coefficient K of the doping element in indium phosphide.

The distribution relationship between the position and the content of a doping element in the crystal rod is given in the following formula (according to Pfann, W.G., "Zone Melting"), ${C}_{x} = K ⋅ {C}_{0} {\left(1-X\right)}^{\left(K-1\right)}$ wherein Cₓ is the solubility of the doping element in the solid phase at different cross sections; X is the ratio of the length of the crystallized portion to the total length of the crystal; C₀ is the solubility of the doping element in the liquid phase in the molten state before crystallization.

That is, the distribution of the doping elements sulfur and tin (K < 1) in indium phosphide crystal is not uniform; Its content gradually increases nonlinearly from the head where the crystal rod begins to the tail of the crystal. Therefore, in the case that the indium phosphide crystal is in the form of a single crystal rod or that the distribution of the doping element(s) in the indium phosphide crystal is not uniform, the range specified in the present application for the content of the doping element(s) in the indium phosphide crystal should be understood to mean that the content of the doping element(s) at any position of the finished single crystal rod (but excluding the tip-most and tail-most portions of the single crystal rod that should be discarded during processing) falls within the specified range.

The indium phosphide crystals provided herein may also be in the form of a single crystal wafer. The single crystal wafer can be obtained, for example, by cutting an indium phosphide single crystal rod. When the indium phosphide crystal is in the form of a single crystal wafer, the types of the doping element(s) in the indium phosphide crystal and the content of the doping element(s) in the crystal are also as described above.

The indium phosphide crystal of the present application is an N-type indium phosphide single crystal. In some preferred embodiments of the present application, the carrier concentration of the indium phosphide single crystal is 1×10¹⁷ cm⁻³ to 5×10¹⁹ cm⁻³, for example, 1×10¹⁸ cm⁻³ to 1×10¹⁹ cm⁻³, preferably 1×10¹⁸ cm⁻³ to 8×10¹⁸ cm⁻³, or 1×10¹⁷ cm⁻³ to 9×10¹⁷ cm⁻³, preferably 3×10¹⁷ cm⁻³ to 5×10¹⁷ cm⁻³.

In this application, the carrier concentration refers to the number of carriers per unit volume (cm³). It equals the concentration of ionized impurities in the absence of compensation at room temperature. The carrier concentration can be measured by using methods well known in the art, for example, by means of a Hall instrument.

The indium phosphide single crystal of the present application has low etch pit density and uniform etch pit distribution. In some preferred embodiments of the present application, the average etch pit density of the indium phosphide crystal may be 800/cm² or lower, or 500/cm² or lower, or 100/cm² or lower, even 50/cm² or lower.

In the present application, the etch pit density of the indium phosphide single crystal doped with sulfur and tin is determined by the method described in GB/T20230-2022 "Indium Phosphide Single Crystal".

Still another aspect of the present application provides a preparation method of an indium phosphide crystal, the method comprising a step of placing phosphorus, an indium phosphide polycrystal, a doping agent comprising an element sulfur and a doping agent comprising an element tin or a doping agent comprising both an element sulfur and an element tin, together with a sealant, into a growth vessel such as a crucible provided with a seed crystal; and a step of placing said vessel in a crystal growth furnace and heating to a temperature of the melting point of indium phosphide or higher. Preferably, the amount of element sulfur in the indium phosphide crystal is 0.5 ppm to 500 ppm, for example, 0.5 ppm, 0.8 ppm, 1 ppm, 2 ppm, 3 ppm, 4 ppm, 5 ppm, 10 ppm, 20 ppm, 40 ppm, 50 ppm, 80 ppm, 100 ppm, 200 ppm, 300 ppm, 400 ppm, 500 ppm, and the like; Meanwhile, the amount of element tin in the indium phosphide crystal is preferably 0.5 ppm to 1000 ppm, for example, 0.5 ppm, 1 ppm, 2 ppm, 3 ppm, 4 ppm, 5 ppm, 6 ppm, 7 ppm, 8 ppm, 9 ppm, 10 ppm, 20 ppm, 40 ppm, 50 ppm, 80 ppm, 100 ppm, 200 ppm, 300 ppm, 400 ppm, 500 ppm, 800 ppm, 1000 ppm, or the like, or within an arbitrary range formed with any of the above relative amounts or any of the relative amounts disclosed in the examples of the present application as end values.

In the present application, the amounts of the element sulfur and the element tin in indium phosphide crystals is determined by Glow Discharge Mass Spectrometry (GDMS). In a glow discharge ion source, a potential difference is applied between the cathode (the sample being analyzed) and the anode, and a plasma is sustained by introducing an inert gas (typically argon). The inert gas ions and fast neutral species formed in the plasma are attracted to the sample surface, and their impact causes sputtering of the sample surface to produce neutral species. These neutral particles diffuse into the plasma and are subsequently ionized in the equipotential region of the plasma, and can then be extracted into mass spectrometry for quantitative analysis. For example, it can be carried out in accordance with the current testing standard-"DB35/T 1146-2011 Impurity Content in Silicon Materials Measured by Glow discharge Mass Spectrometry".

Herein, the term "doping element" or "dopant" is used to mean the substance used to provide an element such as sulfur or tin during the preparation of indium phosphide crystals. Simple substances of sulfur and tin may be used. Sulfur-containing compounds and/or tin-containing compounds suitable for industrial production environments may also be used. For example, in some preferred embodiments of the present application, the doping agent comprising the element S is selected from the group consisting of sulfur, sulfides of indium (In₂S₃ and/or In₂S), or mixtures thereof. For example, in some preferred embodiments of the present application, the doping agent comprising the element Sn is selected from the group consisting of tin, a phosphide of tin, an alloy of tin and indium, or mixtures thereof. In addition, sulfur and tin may also be present in the same doping agent, in which case the doping agent is both a sulfur-containing doping agent and a tin-containing doping agent. The doping agent used in the present application is preferably of high purity, preferably 99.00% or higher, for example 99.99% or higher.

In the present application, the apparatus used in the preparation method of indium phosphide crystal (for example, a growth vessel, a melting furnace, etc.) may be conventional apparatus known or commonly used in the art for preparing an N-type indium phosphide single crystal or a P-type indium phosphide single crystal.

In the present application, the raw materials including phosphorus, an indium phosphide polycrystal, a doping element and a sealant used in the preparation method of indium phosphide crystal may all be conventional raw materials known in the art for preparing N-type or P-type indium phosphide single crystals, which may be prepared in-house or obtained commercially. These raw materials are generally of high purity, preferably 99.00% or higher, for example 99.99% or higher.

In the present application, the operation of placing phosphorus, an indium phosphide polycrystal, a doping agent comprising an element sulfur and a doping agent comprising an element tin or a doping agent comprising both an element sulfur and an element tin, and a sealant into a growth vessel may be implemented in a variety of ways. For example, phosphorus, an indium phosphide polycrystal, a doping agent comprising an element sulfur and a doping agent comprising an element tin or a doping agent comprising both an element sulfur and an element tin; or a doping agent comprising an element sulfur and/or a doping agent comprising an element tin or a doping agent comprising both an element sulfur and an element tin may be pre-mixed into the indium phosphide polycrystal (or the doping agent may be introduced during the preparation of the indium phosphide polycrystal to form an indium phosphide polycrystal containing the doping element) before being added to the growth vessel, or ;he like. All of these implementations may be used to prepare the indium phosphide crystals of the present application. On this basis, other equivalent implementations can also be conceived by those skilled in the art, and all of the above implementations and other equivalent implementations are considered to be within the scope of the disclosure of this application.

In some preferred embodiments of the present application, the amount(s) of the doping agent comprising an element sulfur, the doping agent comprising an element tin or the doping agent comprising both an element sulfur and an element tin may be controlled so that the element sulfur in the indium phosphide crystal is present in an amount of 0.5 ppm to 500 ppm, and the element tin in the indium phosphide crystal is present in an amount of 0.5 ppm to 1000 ppm, more preferably, so that the carrier concentration of the resulting indium phosphide single crystal rod within effective length is 1×10¹⁷ cm⁻³ to 5×10¹⁹ cm⁻³, preferably 1×10¹⁸ cm⁻³ to 1×10¹⁹ cm⁻³.

In some embodiments, the preparation method of an indium phosphide crystal further comprises:
a step of stepwise cooling the melt in the vessel to obtain the N-type indium phosphide single crystal.

In some preferred embodiments, the step of placing said vessel in a crystal growth furnace and heating to a temperature of the melting point of indium phosphide or higher comprises the steps of: placing said vessel in a crystal growth furnace and heating using a multi-temperature zone system, preferably establishing a temperature gradient of 0.1-10.0 °C/cm in the single crystal rod growth zone, so that the temperature is increased and maintained at the melting point of indium phosphide or higher; then stepwise cooling the melt in the resulting vessel to obtain the N-type indium phosphide single crystal.

The amounts of the raw materials including phosphorus, an indium phosphide polycrystal, a doping element and a sealant used in the preparation method of indium phosphide crystal of the present application may be determined by a person skilled in the art according to actual needs.

In some preferred embodiments of the present application, the method of preparing crystals is selected from a vertical Bridgman method (VB), a vertical gradient freeze method (VGF), a vapor-pressure-controlled Czochralski method (VCZ), or a vertical crucible growth method.

In some preferred embodiments of the present application, the method of preparing the crystals is vertical gradient freeze method (VGF), in which the crucible may be moved in a temperature field or the crucible may remain stationary with changes in the temperature field.

In some preferred embodiments of the present application, vertical gradient freeze method (VGF) is employed, comprising the steps of:
1) a step of placing phosphorus, an indium phosphide polycrystal, a doping agent comprising an element sulfur and a doping agent comprising an element tin or a doping agent comprising both an element sulfur and an element tin, together with boron oxide as a sealant, into a crucible provided with a seed crystal;
2) placing the crucible of step 1) in a growth tube (preferably a quartz tube, but other types of growth tubes may also be used) and sealing the growth tube under vacuum;
3) placing the sealed growth tube with crucible of step 2) in a crystal growth furnace (preferably heating using a multi-temperature zone system, more preferably establishing a temperature gradient of 0.1-10.0 °C/cm in the single crystal rod growth zone), so that the temperature is increased and maintained at the melting point of indium phosphide or higher;
4) stepwise cooling the melt in the resulting crucible of step 3) to obtain the N-type indium phosphide single crystal comprising sulfur and tin.

The growth vessel for the indium phosphide single crystal rod may be prepared with a suitable crucible material, such as a pyrolytic boron nitride (PBN) crucible. The vessel or crucible for single crystal growth comprises a cylindrical main body having a diameter slightly larger than the diameter of the indium phosphide single crystal rod doped with sulfur and tin to be prepared, a bottom seed crystal (also called crystal seed) tank with a small diameter, and a conical transition zone between the bottom seed crystal tank and the cylindrical main body. The seed crystal tank is used for accommodating cylindrical seed crystals for the preparation of indium phosphide single crystals.

The crystal orientation of the upper end face of the seed crystal is the surface crystal orientation of the indium phosphide single crystal substrate doped with sulfur and tin desired to be obtained, for example (100) or a surface crystal orientation deflected at an angle to the adjacent crystal orientation axis with respect to the (100) crystal orientation.

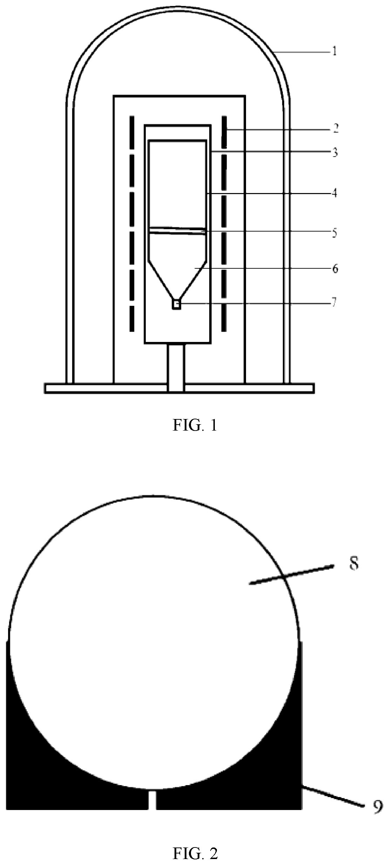

As shown in FIG. 1, a suitable sealant 5 (such as boron oxide) is placed in a crucible 4 together with raw materials 6, wherein the raw materials comprise phosphorus, an indium phosphide polycrystal, and a doping agent comprising sulfur and a doping agent comprising tin or a doping agent comprising both sulfur and tin. The sealant can inhibit the decomposition of indium phosphide materials at high temperatures, and meanwhile can isolate the inner wall of the crucible from the surface of the melt or the solid single crystal rod in the process of single crystal growth, thereby reducing the adhesion between the surface of the grown single crystal rod and the inner wall of the crucible, and making it easier to obtain a complete indium phosphide single crystal rod doped with sulfur and tin. The amount of the sealant used is conventional in the art.

According to the above preparation method of the present application, an indium phosphide crystal according to the first aspect of the present application can be provided, wherein the indium phosphide crystal is a N-type indium phosphide single crystal co-doped with sulfur and tin.

Another aspect of the present application provides the use of a combination of a doping agent containing an element sulfur and a doping agent containing an element tin or use of a doping agent containing both sulfur and tin for reducing etch pit density, reducing twin defects, and/or improving the yield of indium phosphide crystals while increasing carrier concentration during the production process of indium phosphide crystals. In preferred embodiments, the element sulfur in the obtained indium phosphide crystal is present in an amount of 0.5 ppm to 500 ppm, and the element tin is present in an amount of 0.5 ppm to 1000 ppm.

The present application further provides an indium phosphide single crystal wafer, prepared from the N-type indium phosphide single crystal as described above or obtained by the method as described above. The indium phosphide single crystal wafer may be prepared using conventional methods in this field from the N-type indium phosphide single crystal as described above, or prepared from the N-type indium phosphide single crystal obtained by the method as described above. The indium phosphide single crystal wafer doped with sulfur and tin (also referred to as "sulfur-doped and tin-doped indium phosphide single crystal wafer") can be prepared by cutting the indium phosphide single crystal rod doped with sulfur and tin of the present application. Industrial preparation methods typically include the steps of cutting out a rough wafer from a single crystal rod, edge grinding the rough wafer, lapping, rough polishing, fine polishing, cleaning, drying, and so on.

In the present application, the diameter of a single crystal wafer should be understood as follows: When a single crystal wafer is circular, it refers to the diameter of the circle; When a single crystal wafer has other shapes (such as irregular circles, squares, rectangles, etc.), it refers to the diameter of a circle formed by drawing a circle with the center of the single crystal wafer as the center of the circle so that the circle includes all parts of the single crystal wafer.

In the present application, the term "effective length" means the actual length that a single crystal rod can be used for cutting into single crystal wafers.

The sulfur-doped and tin-doped indium phosphide single crystal wafer of the present application has a thickness of from 200 µm to 2000 µm, preferably from 300 µm to 1200µm.

The sulfur-doped and tin-doped indium phosphide single crystal wafer of the present application is made by cutting a sulfur-doped and tin-doped indium phosphide single crystal rod, which is a single crystal rod with a circular transverse cross section (referred to as a circular single crystal rod for short), and the diameter of the circular cross section is usually not more than 12 inches, preferably 1 inch to 8 inches. Apparently, the sulfur-doped and tin-doped indium phosphide single crystal rod may also be a single crystal rod having another shape in the transverse cross section, for example, a sulfur-doped and tin-doped indium phosphide single crystal rod having a square (square or rectangle) in the transverse cross section obtained by processing a circular single crystal rod, and in this case, the cut crystal wafer is a non-circular sulfur-doped and tin-doped indium phosphide single crystal wafer.

The sulfur-doped and tin-doped indium phosphide single crystal wafer of the present application is preferably cut from the single crystal rod produced by the preparation method of the sulfur-doped and tin-doped indium phosphide single crystal rod as described herein. The processing of the sulfur-doped and tin-doped indium phosphide single crystal wafer of the present application is exactly the same as the processing of a conventional sulfur-doped single crystal. A specific example of the processing method of the sulfur-doped and tin-doped indium phosphide single crystal wafer of the present application may be referred to Chinese Patent Publication CN 116043318 A, the content of which is incorporated herein by reference.

The indium phosphide single crystal wafer as described herein may be used for epitaxial growth thereon or further fabrication or processing into devices including, but not limited to, optoelectronic devices such as lasers, detectors, light emitting diodes, etc., or electronic devices such as HBT, MESFET, PHEMT, etc.

Still another aspect of the present application provides an electronic device or optoelectronic device, prepared from the indium phosphide single crystal wafer as described above or containing a component prepared from the indium phosphide single crystal wafer as described above. The optoelectronic device includes, for example, a laser, a detector, a light emitting diode, and the like, and the electronic device includes, for example, an HBT, a MESFET, a PHEMT, and the like.

The present application may be illustrated by the following embodiments:
Embodiment 1. An indium phosphide crystal, which is an N-type indium phosphide single crystal, wherein the indium phosphide crystal comprises 0.5 ppm to 500 ppm of sulfur and 0.5 ppm to 1000 ppm of tin.
Embodiment 2. The indium phosphide crystal according to Embodiment 1, wherein element sulfur is present in an amount of 0.5 ppm to 500 ppm, preferably 0.8 ppm to 400 ppm, more preferably 1 ppm to 300 ppm.
Embodiment 3. The indium phosphide crystal according to Embodiment 1 or 2, wherein element tin is present in an amount of 0.5ppm to 1000 ppm, preferably 1 ppm to 500 ppm, more preferably 2 ppm to 300 ppm.
Embodiment 4. The indium phosphide crystal according to Embodiments 1 to 3, wherein the indium phosphide crystal has a carrier concentration of 1×10¹⁷ cm⁻³ to 5×10¹⁹ cm⁻³, for example 1×10¹⁸ cm⁻³ to 1×10¹⁹ cm⁻³, preferably 1×10¹⁸ cm⁻³ to 8×10¹⁸ cm⁻³, or for example 1×10¹⁷ cm⁻³ to 9×10¹⁷ cm⁻³, preferably 3×10¹⁷ cm⁻³ to 5×10¹⁷ cm⁻³.
Embodiment 5. The indium phosphide crystal according to any one of Embodiments 1 to 4, wherein the indium phosphide crystal is in the form of an indium phosphide single crystal rod.
6. A preparation method of an N-type indium phosphide single crystal, comprising a step of placing phosphorus, an indium phosphide polycrystal, a doping agent comprising an element sulfur and a doping agent comprising an element tin or a doping agent comprising both an element sulfur and an element tin, together with a sealant, into a growth vessel such as a crucible provided with a seed crystal; and
   a step of placing said vessel in a crystal growth furnace and heating to a temperature of the melting point of indium phosphide or higher.
Embodiment 7. The method according to Embodiment 6, further comprising a step of stepwise cooling the melt in the vessel to obtain the N-type indium phosphide single crystal.
Embodiment 8. The use according to Embodiment 6 or 7, wherein the step of placing said vessel in a crystal growth furnace and heating to a temperature of the melting point of indium phosphide or higher comprises: placing said vessel in a crystal growth furnace and heating using a multi-temperature zone system, preferably establishing a temperature gradient of 0.1-10.0 °C/cm in the single crystal rod growth zone, so that the temperature is increased and maintained at the melting point of indium phosphide or higher.
Embodiment 9. The method according to any one of Embodiments 6 to 8, wherein the element sulfur in the obtained indium phosphide crystal is present in an amount of 0.5 ppm to 500 ppm, and the element tin in the obtained indium phosphide crystal is present in an amount of 0.5 ppm to 1000 ppm.
Embodiment 10. The method according to any one of Embodiments 6 to 9, wherein
   the doping agent comprising an element sulfur is selected from the group consisting of sulfur, a sulfide of indium, or a mixture thereof;
   the doping agent comprising an element tin is selected from the group consisting of tin, a phosphide of tin, an alloy of tin and indium, or a mixture thereof;
Embodiment 11. The method according to any one of Embodiments 6 to 10, wherein the method is selected from a vertical Bridgman method (VB), a vertical gradient freeze method (VGF), a vapor-pressure-controlled Czochralski method (VCZ), or a vertical crucible growth method.
Embodiment 12. Use of a combination of a doping agent comprising an element sulfur and a doping agent comprising an element tin or use of a doping agent comprising both an element sulfur and an element tin for reducing etch pit density, reducing twin defects, and/or improving the yield of indium phosphide crystals while increasing carrier concentration during the production process of indium phosphide crystals.
Embodiment 13. An indium phosphide single crystal wafer prepared from the indium phosphide crystal according to any one of Embodiments 1 to 5, or prepared from the indium phosphide crystal obtained by the method according to any one of Embodiments 6 to 11.
Embodiment 14. The indium phosphide single crystal wafer according to Embodiment 13, wherein the indium phosphide single crystal wafer is used for epitaxial growth thereon or further fabrication into devices comprising optoelectronic devices such as lasers, detectors, light emitting diodes, etc., or electronic devices such as HBT, MESFET, PHEMT, etc.
Embodiment 15. An electronic device or optoelectronic device, prepared from the indium phosphide single crystal wafer according to any one of Embodiments 13 to 14 or comprising a component prepared from the indium phosphide single crystal wafer according to any one of Embodiments 13 to 14.
Embodiment 16. The optoelectronic device according to Embodiment 15, being a laser, a detector, or a light emitting diode, or the like.
Embodiment 17. The optoelectronic device according to Embodiment 15, being an HBT, a MESFET, or a PHEMT, or the like.

The indium phosphide crystal comprising sulfur and tin obtained in the present application has less twin crystals, low defect density and high yield and relatively good electrical properties, and can greatly reduce the cost, so that it can be widely applied to optoelectronic devices such as lasers and photodetectors, and high-frequency electronic devices and the like.

### Examples

In order to better understand the present application, the present application will be described in detail below with reference to examples and drawings, but it should be recognized that these examples are merely illustrative of the present application, and are not intended to limit the present application.

Unless otherwise stated, all parts, percentages, and ratios reported in the following examples are based on weight, and all reagents used in the examples are commercially available or synthesized by conventional methods, and can be directly obtained without further treatment, and the instruments used in the examples are commercially available.

### Production Equipment

FIG. 1 is a cross-sectional view of an embodiment of a crystal growth apparatus containing a sealed vessel for the growth of sulfur-doped and tin-doped indium phosphide single crystal. The apparatus is provided in the high pressure chamber 1 and may comprise a growth tube 3 located in the furnace, wherein the heater 2 consists of a plurality of temperature zones, each of which is individually controlled by a computer controlled by a control system. The pressure within the high pressure chamber 1 is adjusted to, for example, about 2 MPa to 4MPa. The temperature of each temperature zone is adjusted to provide the temperature profile and temperature gradient required to control the solidification of the melt; and the temperature profile and temperature gradient in the furnace are adjusted so that the crystallization interface moves upwardly through the melt as desired, for example, to establish a temperature gradient of 0.1 °C/cm to 10 °C/cm in the single crystal rod growth zone and to establish a relatively low temperature gradient at the seed crystal end. The crucible 4 in the growth tube (quartz tube) 3 has a seed crystal tank for holding a seed crystal 7, and a single crystal grows along the top of the seed crystal 7. In one embodiment, the crucible 4 may be a pyrolytic boron nitride structure having a cylindrical crystal growth portion, a seed crystal tank cylinder with a smaller diameter and a conical transition portion. The crystal growth section is open at the top of the crucible 4 with a diameter equal to the diameter of the desired crystal product. In an exemplary embodiment, the seed crystal tank cylinder at the bottom of the crucible 4 may have a closed bottom and a diameter slightly larger than the seed crystal 7. The cylindrical crystal growth portion and the seed crystal tank cylinder may have straight walls, or may be tapered gradually outwardly by about 1-30 degrees to facilitate removal of crystal from the crucible 4.

The crucible 4 is adapted to fit inside the growth tube 3 with a narrow gap therebetween. The growth tube 3 is closed at the bottom of its seed crystal tank region and sealed at the top after filling the crucible and raw material.

Since the growth tube-crucible assembly has a funnel shape, a growth tube support is required to adapt to the funnel shape and keep the growth tube 3 stable and upright inside the furnace. In other embodiments, the growth tube-crucible assembly may be configured in different shapes, and the basic structure of the growth tube support will vary depending on the different shapes.

In the VGF crystal growth method, the crystallization temperature gradient of a fixed heat source is moved via an electrical control way, while the crystal remains stationary.

In order to implement vertical gradient freeze growth, the desired temperature gradient profile must be established within the furnace, and the power of each heating zone of the furnace is individually controlled by a computer that is programmed to heat and cool to meet the requirements for the crystallization temperature and temperature gradient of the furnace. For the production of single crystal rods, for example, the temperature fluctuation of the furnace may need to be controlled to less than ± 1°C. During the furnace preparation process, phosphorus and indium phosphide polycrystal raw materials 6 containing a doping agent are loaded into the growth tube 3.

In an embodiment, indium sulfide and simple substance of tin are used as a doping agent. A seed crystal with a (100) orientation is loaded into a seed crystal tank of the crucible, followed by feeding. The raw materials (comprising the appropriate amounts of doping agent(s)) are fed into a crucible, which is then placed into the growth tube 3. The growth tube with the crucible is connected to a vacuum system for evacuation, and subsequently sealed. The sealed growth tube is then loaded into the furnace, as shown in FIG. 1. The furnace is turned on to heat the growth tube and its contents to a temperature above 1050°C, the melting point of indium phosphide. The temperature gradient at the crystallization interface can be adjusted to 0.1-10 °C/cm according to different positions of the single crystal rod. The overall temperature profile is adjusted to give a crystallization rate of 2-5 mm/h.

Sulfur-doped and tin-doped indium phosphide single crystal rods grown using the above-described exemplary growth process parameters can be used to cut wafers.

The designed growth procedure can obtain a suitable growth rate and a suitable temperature gradient near the solid-liquid interface from the seed crystal end to the completion of single crystal growth (or all the melt solidifies and grows into a solid single crystal).

Under this growth procedure and the conditions of adding appropriate amounts of doping agent(s), the single crystal growth is maintained throughout the entire length of the single crystal rod. For example, sulfur-doped and tin-doped indium phosphide single crystal rods with a diameter of 2-6 inches can be grown.

When all the raw materials loaded in the crucible are solidified, the grown single crystal rod is cooled to room temperature under the temperature-controlled conditions.

### Performance testing

The appearance quality of the prepared sulfur-doped and tin-doped indium phosphide single crystal rods was tested by visual inspection under a fluorescent lamp.

The inspection criteria of the prepared initial wafers of sulfur-doped and tin-doped indium phosphide single crystal were as follows: a single crystal wafer is qualified if it is visually inspected to be intact and has no crack on its surface .

The etch pit density of the indium phosphide single crystal was determined by the method described in GB/T20230-2022 "Indium Phosphide Single Crystal".

The amounts of sulfur and tin in the indium phosphide single crystal are determined by the method specified in the following standard "DB35/T 1146-2011 Impurity Content in Silicon Materials Measured by Glow discharge Mass Spectrometry".

The carrier concentration was measured using a Hall instrument.

### Preparation of sulfur-doped and tin-doped indium phosphide single crystal rods

In the examples below, sulfur-doped and tin-doped indium phosphide single crystal rods having a diameter of 4 inches were prepared; however, sulfur-doped and tin-doped indium phosphide single crystal rods of other diameter sizes can also be prepared using the method of the present application.

Sulfur-doped and tin-doped indium phosphide single crystal rods were prepared according to the following steps.

6 kg of indium phosphide polycrystal and a small amount of 6 N high purity red phosphorus were mixed with sulfur-containing doping agent and tin-containing doping agent in the amounts described in Table 1; and the mixture, together with 0.2 kg of boron oxide sealant, was loaded into a crucible provided with seed crystal. The crucible was placed in the growth tube, and the growth tube was sealed under vacuum at a vacuum of less than 10⁻³ Pa. The growth tube was placed into a crystal growth furnace, using a multi-temperature zone system for heating. The furnace was heated at a heating rate of 20 °C/min to a temperature of 1100 °C, allowing the raw materials in the crucible to melt, and this temperature was maintained for 4 hours. The melt in the crucible thus obtained was cooled, with the temperature gradient of the melt controlled at 2.5 °C/cm and the cooling rate at 0.4 °C/h. Crystallization occurred when the melt was in contact with the seed crystal, yielding the sulfur-doped and tin-doped indium phosphide single crystal rod. After the completion of single crystal growth, the sulfur-doped and tin-doped indium phosphide single crystal rod was cooled to room temperature. Once cooled to room temperature, the single crystal rod was removed from the crucible, yield a single crystal rod of InP single crystal having a diameter of 105 mm. In addition, the indium phosphide single crystal rods of Comparative Examples were prepared using similar methods and parameters, with the only modification that the amounts of raw materials were adjusted.

**Table 1. Production parameters for the preparation of indium phosphide single crystal rods**

| No. | Doping type | Indium sulfide (g) | Tin (g) | Sulfur amount¹ (ppm) | Tin amount² (ppm) | Carrier concentration (CC)³ (cm⁻³) | Etch pit density (EPD) (cm⁻²) | Yield |
|---|---|---|---|---|---|---|---|---|
| Comparative Example 1 | S single-doped | 0.6 | | 1 to 50 | | 0.5E18 to 3E18 | 200 | 25% |
| Comparative Example 2 | S single-doped | 0.9 | | 10 to 80 | | 2E18 to 5E18 | 75 | 28% |
| Comparative Example 3 | S single-doped | 1.2 | | 30 to 150 | | 3.0E18 to 8E18 | 50 | 24% |
| Comparative Example 4 | S and Sn co-doped | 0.6 | 1 | 0.5 to 50 | 0.05 to 10 | 1.8E18 to 6E18 | 50 | 28% |
| Example 1 | S and Sn co-doped | 0.9 | 4 | 10 to 80 | 2 to 60 | 2.2E18 to 7E18 | 75 | 55% |
| Example 2 | S and Sn co-doped | 1.2 | 6 | 30 to 150 | 5 to 80 | 3E18 to 9E18 | 50 | 60% |
| Example 3 | S and Sn co-doped | 1.2 | 12 | 30 to 150 | 30 to 180 | 3.2E18 to 9E18 | 50 | 40% |
| Example 4 | S and Sn co-doped | 1.2 | 20 | 30 to 150 | 30 to 280 | 4.0E18 to 9E18 | 50 | 30% |
| Comparative Example 5 | Sn single-doped | | 12 | | 30 to 100 | 0.5E18 to 6E18 | 1500 | 25% |
| Comparative Example 6 | Sn single-doped | | 15 | | 50 to 150 | 0.9E18 to 7E18 | 500 | 20% |

| | | | | | | | | |
|---|---|---|---|---|---|---|---|---|
| ¹, ², ³: Since the prepared single crystals are in the form of single crystal rods, the sulfur amount, tin amount, and carrier concentration measured at different cross sections along the growth direction of the single crystal rod vary. Here, the minimum and maximum values of sulfur amount, tin amount, and carrier concentration, respectively, at different positions in the single crystal-yielding part of a single crystal rod are provided. | | | | | | | | |

From the experimental data in Table 1, it can be seen that single doping with either sulfur or tin resulted in low crystal yield, and single doping with tin further leaded to relatively high etch pit density; co-doping with sulfur and tin leads to an etch pit density that was significantly lower than that of crystals single-doped with tin, and equivalent to that of crystals single-doped with sulfur. However, co-doping with sulfur and tin at the defined amounts (0.5 ppm to 500 ppm for sulfur and 0.5 ppm to 1000 ppm for tin) greatly improved the crystal yield. In addition, as shown by the data of Comparative Example 4, when the crystal was co-doping with sulfur and tin but the sulfur and/or tin amount(s) was/were not within the specified range (sulfur: 0.5 ppm to 500 ppm, tin: 0.5 ppm to 1000 ppm), the effect of improving the crystal yield was insignificant. As shown by the data of Examples 1 to 4, for crystals co-doped with sulfur and tin, when the amount of sulfur in the indium phosphide crystal is equal to or more than 10 ppm and equal to or less than 150 ppm, and the amount of tin in the indium phosphide crystal is equal to or more than 2 ppm and equal to or less than 180 ppm, the most significant improvement in yield were achieved.

Conclusion: Co-doping with sulfur and tin results in a smaller etch pit density than that of single doping with tin, and higher yield than that of single doping with sulfur or single doping with tin; When the indium phosphide crystal contain 0.5 ppm to 500 ppm of sulfur and 0.5 ppm to 1000 ppm of tin at the same time, the etch pit density can be reduced, the twin defect can be reduced, and the yield of the indium phosphide crystal can be improved while ensuring the required carrier concentration range; In particular, when the amount of element sulfur is within the range required for the desired carrier concentration and the amount of element tin is within the range of 2 to 200 ppm, the improvement effect of the yield is particularly remarkable.

### Preparation of sulfur-doped and tin-doped indium phosphide single crystal wafers

The sulfur-doped and tin-doped indium phosphide single crystal rods prepared in the above examples were cut into sulfur-doped and tin-doped indium phosphide single crystal wafers according to the following steps.

Cutting: Sulfur-doped and tin-doped indium phosphide single crystal rods were cut with a multi-wire cutting machine into initial single crystal wafers of sulfur-doped and tin-doped indium phosphide single crystals with a thickness of 800 µm. FIG. 2 shows a schematic diagram of a single crystal rod fixing device used in the preparation of a single crystal wafer of the present application. Sulfur-doped and tin-doped indium phosphide single crystal rod 8 was fixed using a fixing device semi-surrounding graphite 9 to conveniently separate it from the single crystal wafers in a subsequent step. During the cutting process, a semi-surrounding graphite fixture was used to fix the cylindrical sulfur-doped and tin-doped indium phosphide single crystal rod. After the cutting was completed, the initial single crystal wafer of sulfur-doped and tin-doped indium phosphide single crystal was manually removed, and the operation was performed by the same personnel under identical conditions.

Chamfering: Each circular single crystal wafer was edge-chamfered using a chamfering machine so that its edge cross-section became arc-shaped.

Fixing: One side of the single crystal wafer was placed on a circular ceramic plate (Ra < 0.5 µm) with a diameter of 5.2 cm and a thickness of 250 µm, and gentle pressure was applied to ensure no air bubbles between the single crystal wafer and the ceramic plate.

Surface treatment: The ceramic plate carrying the single crystal wafer was placed in an etching solution at 35 °C for 12 seconds, the etching solution having a composition of: 1 mol% NH₃, 10 mol% hydrogen peroxide, with the balance being water.

Polishing: The ceramic plate carrying the single crystal wafer was then placed and fixed in the support pad cavity of the polishing machine (in close contact with the ceramic plate). The rough polishing solution shown in Table 3 was first applied to the polishing equipment, and polishing was performed for 60 minutes under the rough polishing conditions shown in Table 2. After cleaning with deionized water (resistivity greater than 17.5 MΩ·cm, measured at 25 °C) and drying, the fine polishing solution shown in Table 3 was then applied to the polishing equipment, and polishing was performed for 6 minutes under the fine polishing conditions shown in Table 3. The ceramic plate carrying the single crystal wafer was then removed and placed on a heating furnace to melt the adhesive. The single crystal wafer was detached from the ceramic plate, cleaned with deionized water, and dried.

Cleaning: a) At 10 °C, the single crystal wafer was immersed for 5 minutes in an aqueous solution containing 0.3 wt% NH₃ and 1.3% by weight (unless otherwise indicated, all solutions below were given in weight percent based on the total weight of the solution) of hydrogen peroxide. b) At 10 °C, the surface of the single crystal wafer was rinsed with deionized water for 3 minutes. c) At 20 °C, the single crystal wafer was immersed for 5 minutes in a 10% by weight hydrogen peroxide solution. d) At 15 °C, the surface of the single crystal wafer was rinsed with deionized water for 3 minutes; e) At 20 °C, the single crystal wafer was immersed for 5 minutes in a 10 wt% ammonia solution. f) At 15 °C, the surface of the single crystal wafer was rinsed with deionized water for 3 minutes. g) The single crystal wafer was placed in a wafer rotary dryer and dried with hot nitrogen.

The thickness of the obtained indium phosphide single crystal wafer was 650 µm, and the performance test results of the obtained indium phosphide single crystal wafers of Examples were shown in Table 4 below, wherein the carrier concentration was measured using a Hall instrument.

**Table 2. Composition of coarse polishing solution and polishing conditions**

| | | | |
|---|---|---|---|
| **Chemical composition (wt.%, calculated based on total weight of chemicals)** | **Sodium dichloroisocyanurate** | | **15.89** |
| | **Sodium pyrophosphate** | | **13.38** |
| | **Sodium bicarbonate** | | **9.07** |
| | **Sodium benzenesulfonate** | | **0.14** |
| | **Sulfur sol** | | **64.06** |
| | **Total chemical concentration** | | **2.60** |
| **Balance (wt.%)** | **Water** | | **97.40** |
| **Polishing conditions** | **Pressure per unit area of crystal wafer, g/cm²** | | **63.75** |
| | **Flow rate of polishing fluid, l/cm² wafer/h** | | **83.75** |
| | **Rotational speed (rpm)** | **Upper plate** | **22.50** |
| | | **Lower plate** | **11.00** |

**Table 3. Composition of fine polishing solution and polishing conditions**

| | | | |
|---|---|---|---|
| **Chemical composition (wt.%, calculated based on total weight of chemicals)** | | **Sodium dichloroisocyanurate** | **33.95** |
| | | **Sodium acid pyrophosphate** | **26.65** |
| | | **Sodium carbonate** | **19.33** |
| | | **Sodium bicarbonate** | **20.25** |
| | | **Sodium benzenesulfonate** | **0.36** |
| | | **Total chemical concentration** | **1.23** |
| **Balance (wt.%)** | | **Water** | **98.77** |
| | **Pressure per unit area of crystal wafer (g/cm²)** | | **58.75** |
| **Polishing conditions** | **Flow rate of polishing fluid (ml/cm² wafer/min)** | | **0.55** |
| | **Rotational speed (rpm)** | **Upper plate** | **37.50** |
| | | **Lower plate** | **22** |

**Table 4. Performance test results of indium phosphide single crystal wafers**

| **No.** | **Average carrier concentration (cm⁻³) of sampled wafer** | **Etch pit density (cm⁻²)** |
|---|---|---|
| **Example 1** | **2.5E18** | **75** |
| **Example 2** | **4.0E18** | **50** |
| **Example 3** | **4.0E18** | **50** |
| **Example 4** | **5.0E18** | **50** |

As shown by the data in Table 4, the InP single wafers cut from the sulfur and tin co-doped indium phosphide single crystal rods prepared according to Examples 1 to 4 of the present application have the characteristics of high carrier density and low etch pit density, and meet the requirements of industrial applications such as optoelectronic devices and electronic devices.

Although the foregoing has been described with reference to specific embodiments of the present application, it will be understood by those skilled in the art that modifications or changes may be made to the embodiments without departing from the principles and spirit of the present application, the scope of which is defined by the appended claims. All of the references, including papers, patent documents, standards, and the like, are incorporated herein by reference in their entireties.

## Claims

1. An indium phosphide crystal, which is an N-type indium phosphide single crystal, wherein the indium phosphide crystal comprises 0.5 ppm to 500 ppm of sulfur and 0.5 ppm to 1000 ppm of tin.

2. The indium phosphide crystal according to claim 1, wherein element sulfur is present in an amount of 0.5 ppm to 500 ppm, preferably 0.8 ppm to 400 ppm, more preferably 1 ppm to 300 ppm.

3. The indium phosphide crystal according to claim 1 or 2, wherein element tin is present in an amount of 0.5ppm to 1000 ppm, preferably 1 ppm to 500 ppm, more preferably 2 ppm to 300 ppm.

4. The indium phosphide crystal according to any one of claims 1 to 3, wherein the indium phosphide crystal has a carrier concentration of 1×10¹⁷ cm⁻³ to 5×10¹⁹ cm⁻³, for example 1×10¹⁸ cm⁻³ to 1×10¹⁹ cm⁻³, preferably 1×10¹⁸ cm⁻³ to 8×10¹⁸ cm⁻³, or for example 1×10¹⁷ cm⁻³ to 9×10¹⁷ cm⁻³, preferably 3×10¹⁷ cm⁻³ to 5×10¹⁷ cm⁻³.

5. The indium phosphide crystal according to any one of claims 1 to 4, wherein the indium phosphide crystal is in the form of an indium phosphide single crystal rod or a single crystal wafer.

6. A preparation method of an N-type indium phosphide single crystal, comprising a step of placing phosphorus, an indium phosphide polycrystal, a doping agent comprising an element sulfur and a doping agent comprising an element tin or a doping agent comprising both an element sulfur and an element tin, together with a sealant, into a growth vessel such as a crucible provided with a seed crystal; and
a step of placing said vessel in a crystal growth furnace and heating to a temperature of the melting point of indium phosphide or higher.

7. The method according to claim 6, further comprising a step of stepwise cooling the melt in the vessel to obtain the N-type indium phosphide single crystal.

8. The method according to claim 6 or 7, wherein the step of placing said vessel in a crystal growth furnace and heating to a temperature of the melting point of indium phosphide or higher comprises: placing said vessel in a crystal growth furnace and heating using a multi-temperature zone system, preferably establishing a temperature gradient of 0.1-10.0 °C/cm in the single crystal rod growth zone, so that the temperature is increased and maintained at the melting point of indium phosphide or higher.

9. The method according to any one of claims 6 to 8, wherein the element sulfur in the obtained indium phosphide crystal is present in an amount of 0.5 ppm to 500 ppm, and the element tin in the obtained indium phosphide crystal is present in an amount of 0.5 ppm to 1000 ppm.

10. The method according to any one of claims 6 to 9, wherein
the doping agent comprising an element sulfur is selected from the group consisting of sulfur, a sulfide of indium, or a mixture thereof;
the doping agent comprising an element tin is selected from the group consisting of tin, a phosphide of tin, an alloy of tin and indium, or a mixture thereof;

11. The method according to any one of claims 6 to 10, wherein the method is selected from a vertical Bridgman method (VB), a vertical gradient freeze method (VGF), a vapor-pressure-controlled Czochralski method (VCZ), or a vertical crucible growth method.

12. Use of a combination of a doping agent comprising an element sulfur and a doping agent comprising an element tin or use of a doping agent comprising both an element sulfur and an element tin for reducing etch pit density, reducing twin defects, and/or improving the yield of indium phosphide crystals while increasing carrier concentration during the production process of indium phosphide crystals.

13. An electronic device or optoelectronic device, prepared from the indium phosphide crystal according to any one of claims 1 to 5 or comprising a component prepared from the indium phosphide crystal according to any one of claims 1 to 5.

14. The optoelectronic device according to claim 13, selected from a laser, a detector, or a light emitting diode.

15. The optoelectronic device according to claim 13, selected from HBT, MESFET, or PHEMT.
